# EUROPEAN PATENT APPLICATION

(11) **EP 4 800 900 A1**
(43) Date of publication of application: **02.09.2026**
(21) Application number: 24910460.5
(22) Date of filing: 25.11.2024
(51) Int. Cl.: H02M 1/06, H02M 1/08, H03K 17/72, H01R 13/24

(54) **DRIVER, SEMICONDUCTOR APPARATUS AND METHOD FOR CONTROLLING SEMICONDUCTOR APPARATUS**

(30) Priority: 27.12.2023 CN 202311838584
(71) Applicant: NR Electric Co., Ltd, Nanjing, Jiangsu 211102 (CN); NR Engineering Co., Ltd., Nanjing, Jiangsu 211102 (CN); NR Electric Power Electronics Co., Ltd., Changzhou, Jiangsu 213025 (CN)
(72) Inventor: LIU, Lei, Nanjing, Jiangsu 211102 (CN); LI, Lele, Nanjing, Jiangsu 211102 (CN); LU, Yu, Nanjing, Jiangsu 211102 (CN); XIANG, Cong, Nanjing, Jiangsu 211102 (CN); ZHOU, Chen, Nanjing, Jiangsu 211102 (CN); LIU, Bin, Nanjing, Jiangsu 211102 (CN); HUANG, Hua, Nanjing, Jiangsu 211102 (CN); ZHANG, Xiaobo, Nanjing, Jiangsu 211102 (CN)
(74) Representative: Grünecker Patent- und Rechtsanwälte PartG mbB
(86) International application number: PCT/CN2024/134176
(87) International publication number: WO 2025/139526

(57) **Abstract**

This application provides a driver, a semiconductor apparatus, and a method for controlling a semiconductor apparatus, and belongs to the field of power electronic device technologies. The driver includes a fixing assembly and a driving assembly. The fixing assembly includes a mounting member and a connecting member, where the connecting member is disposed on the mounting member, and a first positive electrode and a first negative electrode are disposed on the mounting member. The driving assembly includes a driving board, where a second positive electrode and a second negative electrode are disposed on the driving board. The driving board is movably connected to the connecting member, to cause the first positive electrode to be connected to the second positive electrode, and cause the first negative electrode to be connected to the second negative electrode. The driver according to this application has advantages of being convenient for repair, upgrading, and reconstruction, and having low use costs.

## Description

### CROSS-REFERENCE TO RELATED APPLICATIONS

This application claims priority to Chinese Patent Application No. 202311838584.5, filed with the China National Intellectual Property Administration on December 27, 2023 and entitled "DRIVER, SEMICONDUCTOR APPARATUS, AND METHOD FOR CONTROLLING SEMICONDUCTOR APPARATUS", which is incorporated herein by reference in its entirety.

### TECHNICAL FIELD

This application relates to the field of power electronic device technologies, and in particular, to a driver, a semiconductor apparatus, and a method for controlling a semiconductor apparatus.

### BACKGROUND

An integrated gate-commutated thyristor (IGCT) is a fully controlled semiconductor switching device, has advantages such as a high blocking voltage, a strong through-current capacity, a low conduction voltage, and a capability to be connected in series, and is mainly used in a power converter and a motor dragging system.

Currently, the integrated gate-commutated thyristor is formed by a GCT chip and a driving circuit integrally integrated on a circuit board, to satisfy a requirement of a high-voltage electronic apparatus. However, when the driving circuit is faulty, only the entire integrated gate-commutated thyristor can be replaced, which is inconvenient to repair, has high replacement costs, and is not beneficial for upgrading and improvement of the driving circuit.

### SUMMARY

This application provides a driver, a semiconductor apparatus, and a method for controlling a semiconductor apparatus, to facilitate repair and upgrade of a driving circuit, and reduce maintenance costs of an integrated gate-commutated thyristor.

This application provides a driver, including:
a fixing assembly, including a mounting member and a connecting member, where the connecting member is disposed on the mounting member, and a first positive electrode and a first negative electrode are disposed on the mounting member; and
a driving assembly, including a driving board, where a second positive electrode and a second negative electrode are disposed on the driving board, where
the driving board is movably connected to the connecting member, such that the first positive electrode is connected to the second positive electrode, and the first negative electrode is connected to the second negative electrode.

In some implementations, the connecting member includes:
an electric conductor, where at least two electric conductors are provided, and two of the electric conductors are disposed at an interval on the mounting member and are respectively connected to the first positive electrode and the first negative electrode, where
the driving board is inserted between the two electric conductors, and the second positive electrode and the second negative electrode are respectively connected to the two electric conductors.

In some implementations, at least one of the electric conductors is a spring plate, and the spring plate includes:
a connecting portion, disposed on the mounting member;
a contact portion, disposed on the connecting portion, where a part of the contact portion is disposed at an interval from the connecting portion, and a side that faces away from the contact portion is connected to the driving board; and
a support portion, connected between the contact portion and the connecting portion.

In some implementations, the driving assembly further includes a housing provided with a mounting cavity, where
the driving board is disposed in the mounting cavity.

In some implementations, one of the housing and the mounting member is provided with an insertion slot, an insertion member is disposed on an other of the housing and the mounting member, and the insertion member is inserted into the insertion slot.

This application further provides a semiconductor apparatus, including:
a semiconductor device; and
the driver according to any one of the foregoing driver and optional implementations thereof, where the semiconductor device is disposed on the mounting member, the first positive electrode is connected to a gate of the semiconductor device, and the first negative electrode is connected to a cathode of the semiconductor device.

In some implementations, the semiconductor apparatus further includes a heat dissipator disposed on the semiconductor device.

In some implementations, a driving circuit is disposed on the driving board, and the driving circuit includes:
a logic control module, configured to receive and feed back a control signal;
a turn-on triggering module, configured to input a forward current to the semiconductor device when the logic control module receives a turn-on signal, to control the semiconductor device to be turned on;
a turn-off triggering module, configured to input a reverse current to the semiconductor device when the logic control module receives a turn-off signal, to control the semiconductor device to be turned off;
an energy supply module, configured to supply power to the logic control module, the turn-on triggering module, and the turn-off triggering module;
a sampling module, configured to send an abnormal signal to the logic control module when the energy supply module abnormally runs; and
a bypass module, configured to connect the gate and the cathode of the semiconductor device when the logic control module receives the abnormal signal.

In some implementations, the turn-on triggering module includes:
a first energy storage member, where a positive electrode of the first energy storage member is connected to the second negative electrode, and a negative electrode of the first energy storage member is connected to the second positive electrode;
a first diode, where an anode of the first diode is connected to the second positive electrode;
a second diode, where a cathode of the second diode is connected to the second positive electrode;
a first inductor, where an input terminal of the first inductor is connected to a cathode of the first diode, and an output terminal of the first inductor is connected to an anode of the second diode;
a first switch, where one terminal of the first switch is connected to the second negative electrode, and an other terminal of the first switch is connected to the input terminal of the first inductor; and
a second switch, where one terminal of the second switch is connected to the anode of the second diode, and an other terminal of the second switch is connected to the second positive electrode, where
the logic control module is connected to the first switch and the second switch and is configured to: control the first switch and the second switch to close when the turn-on signal is received, and control the second switch to open when a current of the first inductor exceeds a first preset value.

In some implementations, the turn-off triggering module includes:
a second energy storage member, where a positive electrode of the second energy storage member is connected to the second negative electrode; and
a third switch, where one terminal of the third switch is connected to a negative electrode of the second energy storage member, and an other terminal of the third switch is connected to the second positive electrode, where
the logic control module is connected to the third switch and is configured to: control the third switch to close when the turn-off signal is received.

In some implementations, the bypass module includes:
a fourth switch, where one terminal of the fourth switch is connected to the second positive electrode, and an other terminal of the fourth switch is connected to the second negative electrode, where
the logic control module is connected to the fourth switch and is configured to: control the fourth switch to close when the abnormal signal is received.

In some implementations, the driving circuit further includes a trigger maintenance module, and the trigger maintenance module includes:
a third energy storage member, where a positive electrode of the third energy storage member is connected to the second negative electrode;
a second inductor, where an input terminal of the second inductor is connected to the second negative electrode;
a third inductor, where an output terminal of the third inductor is connected to the second positive electrode;
a third diode, where an anode of the third diode is connected to an output terminal of the second inductor, and a cathode of the third diode is connected to an input terminal of the third inductor;
a first capacitor, where one terminal of the first capacitor is connected to the second negative electrode, and an other terminal of the first capacitor is connected to an output terminal of the third inductor; and
a fifth switch, where one terminal of the fifth switch is connected to the anode of the third diode, and an other terminal of the fifth switch is connected to a negative electrode of the third energy storage member, where
the logic control module is connected to the fifth switch and is configured to: control the fifth switch to continuously perform closing and opening actions at a preset frequency when a turn-on triggering maintenance signal is received.

In some implementations, the driving circuit further includes a static voltage equalization resistor, one terminal of the static voltage equalization resistor is connected to an anode of the semiconductor device, and an other terminal of the static voltage equalization resistor is connected to the sampling module.

In some implementations, the semiconductor apparatus further includes a damping loop module, and the damping loop module includes:
a damping resistor, where one terminal of the damping resistor is connected to the anode of the semiconductor device; and
a second capacitor, where one terminal of the second capacitor is connected to an other terminal of the damping resistor, and an other terminal of the second capacitor is connected to the energy supply module.

In some implementations, the driving circuit further includes a dynamic clamping module, and the dynamic clamping module includes:
a lightning arrester, where one terminal of the lightning arrester is connected to the anode of the semiconductor device; and
a sixth switch, where one terminal of the sixth switch is connected to an other terminal of the lightning arrester, and an other terminal of the sixth switch is connected to the anode of the semiconductor device, where
the logic control module is connected to the sixth switch, and is configured to: control the sixth switch to close when a voltage value across the semiconductor device is greater than a withstand value of the lightning arrester.

In some implementations, the driving circuit further includes a current sensor, disposed on the semiconductor device, and connected to the sampling module.

This application provides a method for controlling the semiconductor apparatus according to any one of the foregoing semiconductor apparatus and optional implementations thereof, including:
determining whether the energy supply module normally supplies power; and
closing the fourth switch in a case in which the energy supply module does not normally supply power; or
opening the fourth switch in a case in which the energy supply module normally supplies power;
determining whether the turn-on signal is received; and
closing the first switch and the second switch in a case in which the turn-on signal is received, and opening the second switch in a case in which the current of the first inductor exceeds the first preset value;
determining whether the turn-off signal is received; and
determining, in a case in which the turn-off signal is not received, whether the turn-on signal is received; or
closing the third switch in a case in which the turn-off signal is received; and
determining whether the driver is deenergized; and
determining, in a case in which the driver is not deenergized, whether the turn-on signal is received; or
closing the fourth switch in a case in which the driver is deenergized.

In some implementations, this application provides a method for controlling the semiconductor apparatus according to any one of the second aspect and optional implementations thereof, including:
determining whether the energy supply module normally supplies power; and
closing the fourth switch in a case in which the energy supply module does not normally supply power; or
opening the fourth switch in a case in which the energy supply module normally supplies power;
determining whether the turn-on signal is received; and
closing the first switch and the second switch in a case in which the turn-on signal is received, and opening the second switch in a case in which the current of the first inductor exceeds the first preset value;
determining whether a turn-on maintenance signal is received; and
determining, in a case in which the turn-on maintenance signal is not received, whether the turn-on signal is received; and
cyclically closing and opening the fifth switch at the preset frequency in a case in which the turn-on maintenance signal is received;
determining whether the turn-off signal is received; and
determining, in a case in which the turn-off signal is not received, whether the turn-on signal is received; or
closing the third switch in a case in which the turn-off signal is received; and
determining whether the driver is deenergized; and
determining, in a case in which the driver is not deenergized, whether the turn-on signal is received; or
closing the fourth switch in a case in which the driver is deenergized.

In some implementations, this application provides a method for controlling the semiconductor apparatus according to any one of the second aspect and optional implementations thereof, including:
determining whether the energy supply module normally supplies power; and
closing the fourth switch in a case in which the energy supply module does not normally supply power; or
opening the fourth switch in a case in which the energy supply module normally supplies power;
determining whether the turn-on signal is received; and
closing the first switch and the second switch in a case in which the turn-on signal is received, and opening the second switch in a case in which the current of the first inductor exceeds the first preset value;
determining whether a turn-on maintenance signal is received; and
determining, in a case in which the turn-on maintenance signal is not received, whether the turn-on signal is received; and
cyclically closing and opening the fifth switch at the preset frequency in a case in which the turn-on maintenance signal is received;
determining whether the turn-off signal is received; and
determining, in a case in which the turn-off signal is not received, whether the turn-on signal is received; or
determining, in a case in which the turn-off signal is received, whether a current of the semiconductor device exceeds a second preset value; and
determining, in a case in which the current of the semiconductor device exceeds the second preset value, whether the turn-on maintenance signal is received; or
closing the third switch in a case in which the current of the semiconductor device does not exceed the second preset value;
determining whether a voltage value across the semiconductor device exceeds a withstand value of the lightning arrester; and
determining, in a case in which the voltage value across the semiconductor device does not exceed the withstand value of the lightning arrester, whether the driver is deenergized; or
closing the sixth switch in a case in which the voltage value across the semiconductor device exceeds the withstand value of the lightning arrester; and
determining whether the voltage value across the semiconductor device exceeds a withstand value of the semiconductor device; and
determining, in a case in which the voltage value across the semiconductor device does not exceed the withstand value of the semiconductor device, whether the driver is deenergized; or
closing the first switch and the second switch in a case in which the voltage value across the semiconductor device exceeds the withstand value of the semiconductor device, and opening the second switch in a case in which the current of the first inductor exceeds the first preset value, where
in a case in which the driver is not deenergized, whether the turn-on signal is received is determined; and in a case in which the driver is deenergized, the fourth switch is closed.

In the driver, the semiconductor apparatus, and the method for controlling a semiconductor apparatus provided in this application, the driver is detachably connected to the driving assembly through the fixing assembly, so that the driving assembly can be detached and then be repaired or upgraded and reconstructed, which is more convenient to use the driver, and reduces use costs of the driver.

### BRIEF DESCRIPTION OF THE DRAWINGS

Accompanying drawings herein are incorporated into this specification and constitute a part of this specification, show embodiments that conform to this application, and are used for explaining a principle of this application together with this specification.
FIG. 1 is a circuit diagram of a semiconductor apparatus in the related art;
FIG. 2 is a schematic structural diagram of the semiconductor apparatus in the related art;
FIG. 3 is a schematic structural diagram of a driver according to an embodiment of this application;
FIG. 4 is an enlarged view of a position A in FIG. 3;
FIG. 5 is a schematic structural diagram of a first exemplary semiconductor apparatus according to an embodiment of this application;
FIG. 6 is a schematic structural diagram of a second exemplary semiconductor apparatus according to an embodiment of this application;
FIG. 7 is a circuit diagram of a first exemplary semiconductor apparatus according to an embodiment of this application;
FIG. 8 is a circuit diagram of a second exemplary semiconductor apparatus according to an embodiment of this application;
FIG. 9 is a circuit diagram of a third exemplary semiconductor apparatus according to an embodiment of this application;
FIG. 10 is a circuit diagram of a fourth exemplary semiconductor apparatus according to an embodiment of this application;
FIG. 11 is a flowchart of a first exemplary control method according to an embodiment of this application;
FIG. 12 is a flowchart of a second exemplary control method according to an embodiment of this application; and
FIG. 13 is a flowchart of a third exemplary control method according to an embodiment of this application.

Description of numeral references:
101-semiconductor member; 102-driving member; 103-heat dissipation member;
100-fixing assembly; 110-fixing member; 111-first positive electrode; 112-first negative electrode; 113-insertion plate; 120-spring plate; 121-connecting portion; 122-contact portion; 123-support portion;
200-driving assembly; 210-driving board; 220-connecting finger; 221-second positive electrode; 222-second negative electrode; 230-housing; 231-mounting cavity; 232-limiting plate; 233-insertion slot;
300-semiconductor device;
400-heat dissipator;
C1-first energy storage member; C2-second energy storage member; C3-first capacitor; C4-third energy storage member; C5-second capacitor;
S1-first switch; S2-second switch; S3-third switch; S4-fourth switch; S5-fifth switch; S6-sixth switch;
D1-first diode; D2-second diode; D3-third diode;
L1-first inductor; L2-second inductor; L3-third inductor;
R1-static voltage equalization resistor; R2-damping resistor; R3-lightning arrester; and
I-current sensor.

Specific embodiments of this application are shown by using the foregoing accompanying drawings, and more detailed descriptions will be given below. These accompanying drawings and text descriptions are not intended to limit the scope of concept of this application by any means, but to describe the concept of this application for a person skilled in the art with reference to the specific embodiments.

### DETAILED DESCRIPTION

Exemplary embodiments are described herein in detail, and examples of the embodiments are shown in the accompanying drawings. When the following descriptions are made with reference to the accompanying drawings, unless otherwise indicated, the same numbers in different accompanying drawings indicate the same or similar elements. Implementations described in the following exemplary embodiments do not represent all implementations consistent with this application. Instead, the implementations are merely examples of an apparatus and a method which are consistent with some aspects of this application described in detail in the attached claims.

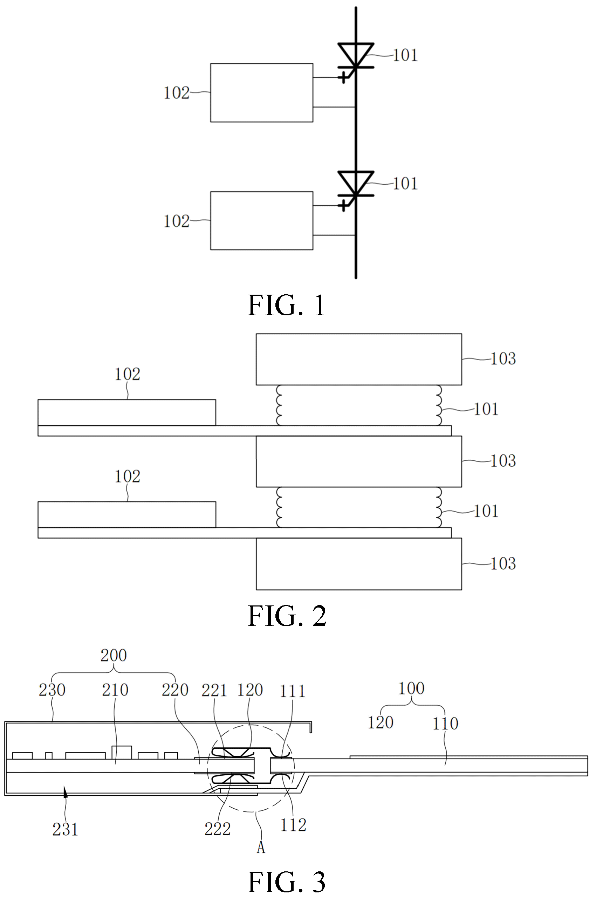

FIG. 1 is a circuit diagram of a semiconductor apparatus in the related art.

Referring to FIG. 1, currently, the semiconductor apparatus includes at least two semiconductor members 101 connected in series, a driving member 102 is configured on each semiconductor member 101, and the driving member 102 is connected to a gate and a cathode of the semiconductor member 101, and is configured to drive the semiconductor member 101 to be turned on or turned off.

FIG. 2 is a schematic structural diagram of the semiconductor apparatus in the related art.

Referring to FIG. 2, during actual application, a plurality of semiconductor members 101 are pressed and connected in series, and a heat dissipation member 103 is disposed on each of two sides of each semiconductor member 101. To ensure reliable contact between the semiconductor member 101 and the heat dissipation member 103, a pressure of 100 KN needs to be applied to the entire semiconductor apparatus. If the driving member 102 in one of the semiconductor members 101 is faulty, after the entire semiconductor apparatus is depressurized, the damaged semiconductor member 101 needs to be removed and replaced with a brand-new driving member 102, and mounting and testing need to be performed on the entire semiconductor apparatus after the driving member 102 is replaced. Therefore, the semiconductor apparatus has defects of being inconvenient for repair and having high repair costs. In addition, if a driving circuit is upgraded and reconstructed, depressurization, disassembly, and overall design and manufacture of the semiconductor apparatus also need to be performed, leading to high upgrade costs.

In view of the foregoing technical problems, embodiments of this application provide a driver, a semiconductor apparatus, and a method for controlling a semiconductor apparatus. The driver includes a fixing assembly and a driving assembly. A semiconductor device is connected to the fixing assembly. The driving assembly and the fixing assembly are detachable. If the driving assembly is faulty, only the driving assembly needs to be detached from the fixing assembly for repair, and semiconductor devices that are pressed together do not need to be depressurized, thereby facilitating repair and reducing repair costs. In addition, it is also beneficial for upgrading and reconstruction.

The following describes the technical solutions of this application and how to resolve the foregoing technical problems according to the technical solutions of this application in detail by using specific embodiments. The following several specific embodiments may be combined with each other, and a same or similar concept or process may not be described in some embodiments again. The following describes the embodiments of this application with reference to the accompanying drawings.

FIG. 3 is a schematic structural diagram of a driver according to an embodiment of this application.

Referring to FIG. 3, the driver according to this embodiment of this application includes a fixing assembly 100 and a driving assembly 200. The fixing assembly 100 includes a mounting member and a connecting member, where the connecting member is disposed on the mounting member, and a first positive electrode 111 and a first negative electrode 112 are disposed on the mounting member. The driving assembly 200 includes a driving board 210, where a second positive electrode 221 and a second negative electrode 222 are disposed on the driving board 210. The driving board 210 is movably connected to the connecting member, to cause the first positive electrode 111 to be connected to the second positive electrode 221, and cause the second positive electrode 221 to be connected to the second negative electrode 222.

The mounting member and the driving board 210 may both be printed circuit boards (PCBs). The first positive electrode 111 and the first negative electrode 112 may be respectively disposed on an upper side and a lower side of an end portion of the mounting member, and the second positive electrode 221 and the second negative electrode 222 may be respectively disposed on an upper side and a lower side of the driving board 210. Optionally, a connecting finger 220 is disposed on the driving board 210, the second positive electrode 221 and the second negative electrode 222 are both disposed on the connecting finger 220, and an insulating layer may be disposed between the second positive electrode 221 and the second negative electrode 222, to avoid conduction between the second positive electrode 221 and the second negative electrode 222.

During actual use, the mounting member is used for connecting a semiconductor device 300, the first positive electrode 111 is connected to a gate of the semiconductor device 300, and the first negative electrode 112 is connected to a cathode of the semiconductor device 300. One end of the driving board 210 that is equipped with the connecting finger 220 is connected to a fixing member 110 through the connecting member, to cause the first positive electrode 111 to be connected to the second positive electrode 221, and cause the first negative electrode 112 to be connected to the second negative electrode 222, so that the driving board 210 is electrically connected to the semiconductor device 300, and the semiconductor device 300 can be controlled, through the driving board 210, to be turned on or turned off.

If the driving board 210 is faulty, or the driving board 210 is upgraded and reconstructed, the driving board 210 may be directly detached from the connecting member without depressurizing and disassembling the entire driver and the semiconductor device 300, to improve convenience of repair, upgrading, and reconstruction, and reduce use costs.

In some embodiments, the connecting member may include at least two electric conductors. Two of the electric conductors are disposed at an interval on the mounting member, and are respectively connected to the first positive electrode 111 and the first negative electrode 112. The driving board 210 is inserted between the two electric conductors, and the first negative electrode 112 and the second negative electrode 222 are respectively connected to the two electric conductors.

The two electric conductors may be respectively connected to an upper side and a lower side of a side end portion of the mounting member. The electric conductor on the upper side is connected to the first positive electrode 111, and the electric conductor on the lower side is connected to the first negative electrode 112. A distance between the two electric conductors may be adapted to a thickness of the connecting finger 220. The connecting finger 220 is inserted between the two electric conductors, to cause the second positive electrode 221 to be connected to the first positive electrode 111 through the electric conductor on the upper side, and cause the second negative electrode 222 to be connected to the first negative electrode 112 through the electric conductor on the lower side.

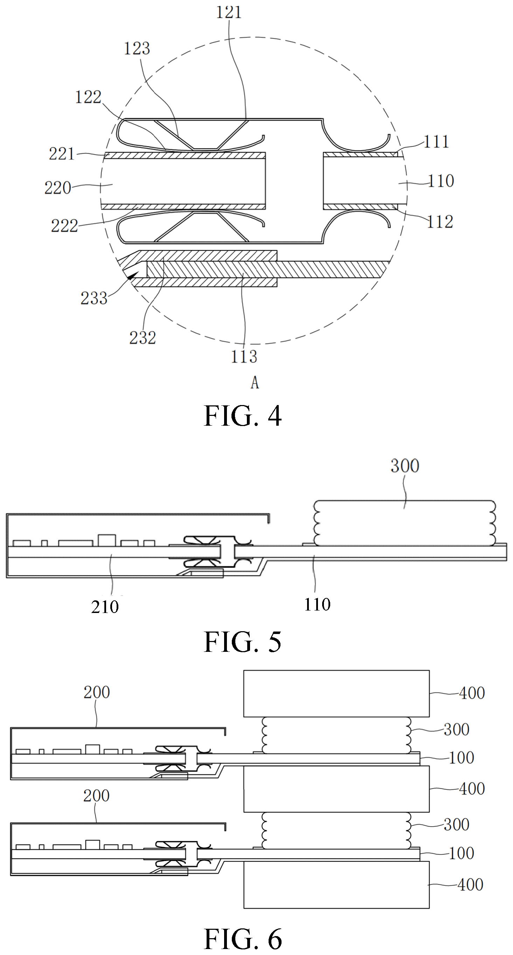

FIG. 4 is an enlarged view of a position A in FIG. 3.

In some embodiments, at least one of the electric conductors may be a spring plate 120, and the spring plate 120 includes: a connecting portion 121, a contact portion 122, and a support portion 123. The connecting portion 121 is disposed on the mounting member. The contact portion 122 is disposed on the connecting portion 121, and a part of the contact portion 122 is disposed at an interval from the connecting portion 121, and is connected to the driving board 210. The support portion 123 is connected between the contact portion 122 and the connecting portion 121.

Referring to FIG. 4, for example, in this embodiment, the two electric conductors are both spring plates 120, one end of the connecting portion 121 is welded to the mounting member, and one end of the connecting portion 121 that faces away from the mounting member is bent and equipped with the contact portion 122, to cause the contact portion 122 and the connecting portion 121 to be arranged at an interval in parallel, and cause the support portion 123 to be welded between the connecting portion 121 and the contact portion 122. Optionally, two support portions 123 are provided, and the support portions 123 are symmetrically disposed between the connecting portion 121 and the contact portion 122.

After the connecting finger 220 is inserted between the two spring plates 120, the spring plates 120 on two sides simultaneously apply an elastic pressure to the connecting finger 220, to cause the contact portion 122 to come into contact with the connecting finger 220. In addition, the support portion 123 may increase a pressure applied by the contact portion 122 to the connecting finger 220, to ensure that the contact portion 122 is in stable contact with a surface of the connecting finger 220, reduce a point contact resistance between the spring plate 120 and the connecting finger 220 to a microohm level, and ensure that the spring plate 120 is electrically connected to the second positive electrode 221 and the second negative electrode 222 on the connecting finger 220.

The spring plate 120 may be made of a high-conductivity copper material, a surface of the spring plate 120 connected to the mounting member may be processed by using a tin-plating process, a surface in contact with the connecting finger 220 may be processed by using a gold-plating process, and the remaining part may be processed by using a nickel-plating process for oxidation prevention.

In some embodiments, the driving assembly 200 may further include a housing 230, provided with a mounting cavity 231, and the driving board 210 is disposed in the mounting cavity 231.

The housing 230 may be made of a metal material or a plastic material, and the driving board 210 may be fixed in the mounting cavity 231 in a manner such as bonding, or connection through a fastener. During actual use, the mounting cavity 231 needs to have at least one opening, and the connecting finger 220 of the driving board 210 extends out through the opening of the mounting cavity 231, to be inserted between the two spring plates 120.

The housing 230 can protect a driving circuit on the driving board 210 from being easily affected by external electromagnetic interference, and can support and protect the driving board 210, to prevent the driving board from being damaged by an external force during use and transportation.

In some embodiments, one of the housing 230 and the mounting member may be provided with an insertion slot 233, an insertion member may be disposed on an other of the housing 230 and the mounting member, and the insertion member is inserted into the insertion slot 233. In this way, the housing 230 and the mounting member are connected, thereby improving positional stability of the driving board 210 during use.

Referring to FIG. 4, for example, a limiting plate 232 is disposed on a bottom wall of an inner side of the housing 230, and the limiting plate 232 is disposed at an interval from a side wall of a bottom portion of the housing 230, to form the insertion slot 233. The insertion member is disposed on a bottom portion of the mounting member. Optionally, the insertion member is an insertion plate 113, and a thickness of the insertion slot 233 is adapted to a thickness of the insertion plate 113. When the driving board 210 is connected to the mounting member, the insertion plate 113 on the mounting member is inserted into the insertion slot 233 on the bottom portion of the housing 230.

Certainly, the insertion slot 233 may alternatively be provided on the mounting member, and the insertion member may alternatively be disposed on the housing 230, so that the housing 230 can also be connected to the mounting member. Details are not described in this embodiment again.

FIG. 5 is a schematic structural diagram of a first exemplary semiconductor apparatus according to an embodiment of this application.

Referring to FIG. 5, based on the foregoing driver, this embodiment of this application further provides a semiconductor apparatus, which includes a semiconductor device 300 and the driver in the foregoing embodiment. The semiconductor device 300 is disposed on the mounting member, the first positive electrode 111 is connected to a gate of the semiconductor device 300, and the first negative electrode 112 is connected to a cathode of the semiconductor device 300.

The semiconductor device 300 may be a gate-commutated thyristor (GCT). Optionally, the mounting member may be provided with a positioning hole, and the semiconductor device 300 is fixed in the positioning hole through welding.

FIG. 6 is a schematic structural diagram of a second exemplary semiconductor apparatus according to an embodiment of this application.

Referring to FIG. 6, in some embodiments, the semiconductor apparatus may further include a heat dissipator 400 disposed on the semiconductor device 300, which is configured to reduce a temperature during running of the semiconductor device 300.

During actual use, a plurality of semiconductor devices 300 may be provided, and the semiconductor devices are pressed and connected in series. For example, as shown in FIG. 6, two semiconductor devices 300 and two drivers are provided, and the semiconductor devices are disposed in one-to-one correspondence with the drivers. A quantity of the heat dissipators 400 may be greater than a quantity of the semiconductor devices 300. A plurality of heat dissipators 400 and a plurality of semiconductor devices 300 are alternately arranged, to cause at least one heat dissipator 400 to be disposed on each of two sides of each semiconductor device 300.

The driving board 210 in each driver controls a corresponding semiconductor device 300 to be turned on or turned off. When a driving board 210 of one of the drivers is damaged or upgraded and reconstructed, the driving board 210 may be directly detached and replaced with a new driving board 210. The semiconductor device 300 and the heat dissipator 400 that are pressed together do not need to be depressurized and detached, so that mounting and detection do not need to be performed again, to shorten repair-and-maintenance duration, and reduce use costs.

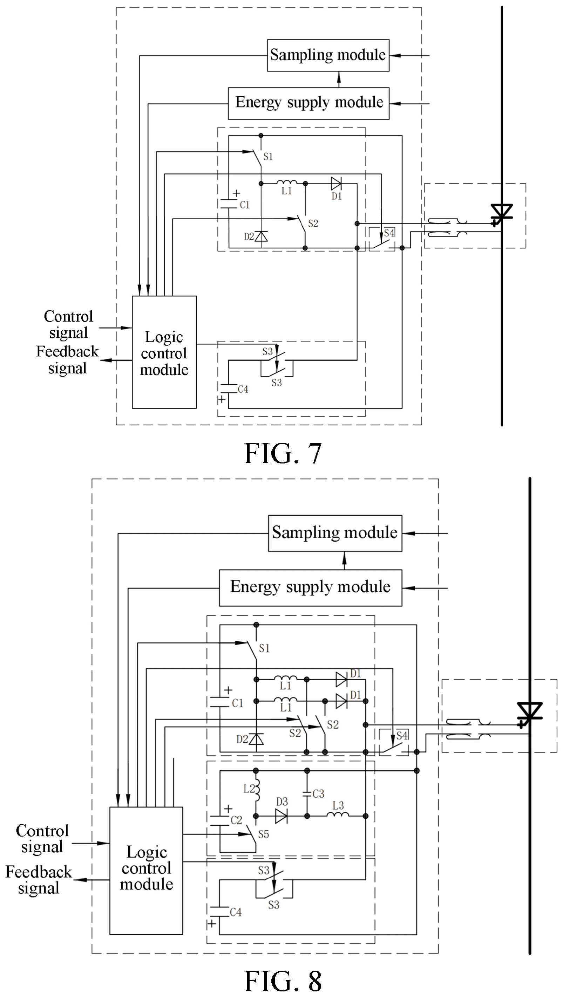

FIG. 7 is a circuit diagram of a first exemplary semiconductor apparatus according to an embodiment of this application.

In some embodiments, a driving circuit is disposed on the driving board. Referring to FIG. 7, the driving circuit may include: a logic control module, a turn-on triggering module, a turn-off triggering module, an energy supply module, a sampling module, and a bypass module.

The logic control module is configured to receive and feed back a control signal. Optionally, the control signal is a pulse signal.

The turn-on triggering module is configured to input a forward current to the semiconductor device when the logic control module receives a turn-on signal, to control the semiconductor device to be turned on.

In some embodiments, the turn-on triggering module may include: a first energy storage member C1, a first diode D1, a second diode D2, a first inductor L1, a first switch S1, and a second switch S2. A positive electrode of the first energy storage member C1 is connected to the second negative electrode, and a negative electrode of the first energy storage member C1 is connected to the second positive electrode. An anode of the first diode D1 is connected to the second positive electrode, and a cathode of the second diode D2 is connected to the second positive electrode. An input terminal of the first inductor L1 is connected to a cathode of the first diode D1, and an output terminal of the first inductor L1 is connected to an anode of the second diode D2. One terminal of the first switch S1 is connected to the second negative electrode, and an other terminal of the first switch S1 is connected to the input terminal of the first inductor L1. One terminal of the second switch S2 is connected to the anode of the second diode D2, and an other terminal of the second switch S2 is connected to the second positive electrode.

The logic control module is connected to the first switch S1 and the second switch S2 and is configured to: control the first switch S1 and the second switch S2 to close when the turn-on signal is received, and control the second switch S2 to open when a current of the first inductor L1 exceeds a first preset value.

When receiving the turn-on signal, the logic control module controls the first switch S1 and the second switch S2 to close. In this case, the first energy storage member C1 is discharged, to cause the current of the first inductor L1 to rise. After a peak value of the current of the first inductor L1 reaches the first preset value, the logic control module controls the second switch S2 to open, to cause the current to enter the semiconductor device through the second positive electrode, the spring plate on the upper side, the first positive electrode, and the gate of the semiconductor device, and then return to the positive electrode of the first energy storage member C1 through the cathode of the semiconductor device, the first negative electrode, the spring plate on the lower side, and the second negative electrode sequentially. After the whole process lasts for at least 10 µs, the current in the circuit attenuates to zero. In this case, the semiconductor device is turned on. Optionally, the first preset value is 100 A.

The turn-off triggering module is configured to input a reverse current to the semiconductor device when the logic control module receives a turn-off signal, to control the semiconductor device to be turned off.

In some embodiments, the turn-off triggering module may include: a second energy storage member C2 and a third switch S3. A positive electrode of the second energy storage member C2 is connected to the second negative electrode. One terminal of the third switch S3 is connected to a negative electrode of the second energy storage member C2, and an other terminal of the third switch S3 is connected to the second positive electrode. The logic control module is connected to the third switch S3 and is configured to: control the third switch S3 to close when the turn-off signal is received.

When receiving the turn-off signal, the logic control module controls the third switch S3 to close, and the second energy storage member C2 is discharged. The current flows into the semiconductor device through the third switch S3, the second negative electrode, the spring plate on the lower side, the first negative electrode, and the cathode of the semiconductor device sequentially, and then returns to the second energy storage member C2 through the gate of the semiconductor device, the first positive electrode, the spring plate on the upper side, and the second positive electrode sequentially. A current of at least 1 KA may flow from the gate of the semiconductor device, to cause the semiconductor device to be turned off.

The energy supply module is configured to supply power to the logic control module, the turn-on triggering module, and the turn-off triggering module. Optionally, the energy supply module is a battery.

The sampling module is configured to send an abnormal signal to the logic control module when the energy supply module abnormally runs. The bypass module is configured to connect the gate and the cathode of the semiconductor device when the logic control module receives the abnormal signal.

In some embodiments, the bypass module may include a fourth switch S4, where one terminal of the fourth switch S4 is connected to the second positive electrode, and an other terminal of the fourth switch S4 is connected to the second negative electrode. The logic control module is connected to the fourth switch S4, and is configured to: control the fourth switch S4 to close when the abnormal signal is received.

When detecting that the energy supply module abnormally runs, the sampling module sends the abnormal signal to the logic control module. After receiving the abnormal signal, the logic control module controls the fourth switch S4 to close. In this case, the fourth switch S4 electrically connects the second positive electrode to the second negative electrode, to cause the gate and the cathode of the semiconductor device to be bypassed, thereby preventing the semiconductor device from being triggered to be turned on when the energy supply module is abnormal.

The logic control module dynamically controls voltages of the gate and the cathode of the semiconductor device, so that voltage damage occurring in the semiconductor apparatus during use can be reduced, and reliability and stability of the semiconductor apparatus during running can be improved.

FIG. 8 is a circuit diagram of a second exemplary semiconductor apparatus according to an embodiment of this application.

Referring to FIG. 8, in some embodiments, the driving circuit may further include a trigger maintenance module, and the trigger maintenance module includes: a third energy storage member C4, a second inductor L2, a third inductor L3, a third diode D3, a first capacitor C3, and a fifth switch S5.

A positive electrode of the third energy storage member C4 is connected to the second negative electrode. An input terminal of the second inductor L2 is connected to the second negative electrode. An output terminal of the third inductor L3 is connected to the second positive electrode. An anode of the third diode D3 is connected to an output terminal of the second inductor L2, and a cathode of the third diode D3 is connected to an input terminal of the third inductor L3. One terminal of the first capacitor C3 is connected to the second negative electrode, and an other terminal of the first capacitor C3 is connected to an output terminal of the third inductor L3. One terminal of the fifth switch S5 is connected to the anode of the third diode D3, and an other terminal of the fifth switch S5 is connected to a negative electrode of the third energy storage member C4. The logic control module is connected to the fifth switch S5 and is configured to: control the fifth switch S5 to continuously perform closing and opening actions at a preset frequency when a turn-on triggering maintenance signal is received.

When the semiconductor device is in a turned-on state, if receiving the trigger maintenance signal, the logic control module controls the fifth switch S5 to continuously perform closing and opening actions at the preset frequency. Each time the fifth switch S5 performs closing and opening actions, a forward current can be applied between the gate and the cathode of the semiconductor device. The forward current may reach at least 1 A, so that the semiconductor device can be continuously in the turned-on state.

Optionally, two first inductors L1, two first switches S1, and two first diodes D1 in the turn-on triggering circuit are provided. Each group of the first inductor L1, the first switch S1, and the first diode D1 are connected in series to form an output current circuit, and two output current circuits are disposed in parallel. When receiving the turn-on signal, the logic control module simultaneously controls the two first switches S1 to close, so that a current output by the two output current circuits may have a phase delay, which can ensure that the semiconductor device can be accurately triggered to be turned on.

Optionally, at least two third switches S3 are provided in the turn-off triggering circuit, and all the third switches S3 are disposed in parallel. When receiving the turn-off signal, the logic control module simultaneously controls all the third switches S3 to close, so that all the third switches S3 connected in parallel share a current of nearly 10 KA generated by the semiconductor device at a turn-off moment, thereby preventing the third switches S3 from being damaged by an excessively large current flowing through the third switches S3.

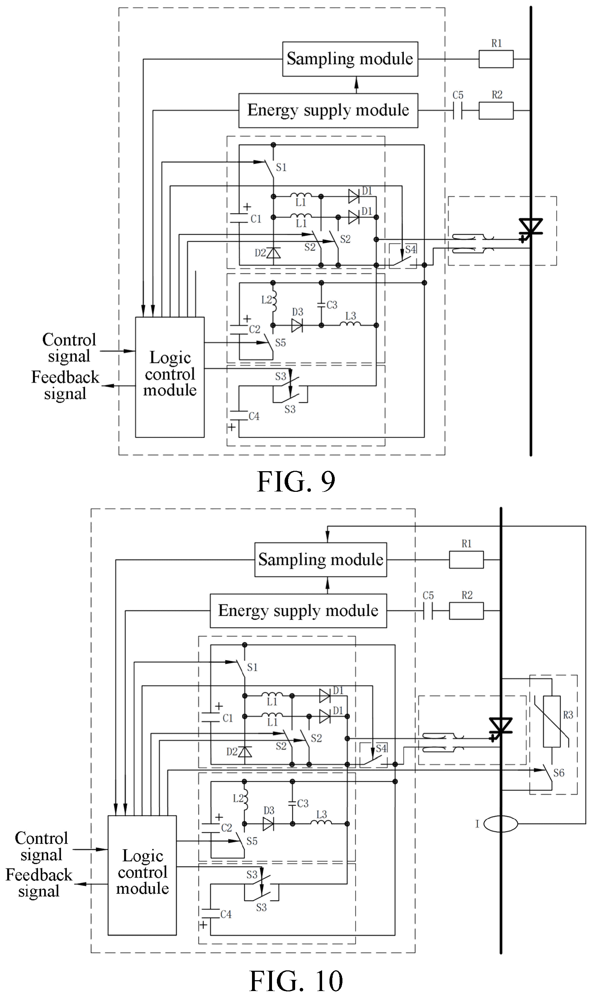

FIG. 9 is a circuit diagram of a third exemplary semiconductor apparatus according to an embodiment of this application.

In some embodiments, the driving circuit may further include a static voltage equalization resistor R1, one terminal of the static voltage equalization resistor is connected to an anode of the semiconductor device, and an other terminal of the static voltage equalization resistor is connected to the sampling module. In this case, the sampling module can monitor a voltage value across the semiconductor device through the static voltage equalization resistor R1, to send the control signal to the logic control module when the voltage value across the semiconductor device exceeds a withstand voltage of the semiconductor device.

In some embodiments, the driving circuit may further include a damping loop module, which includes a damping resistor R2 and a second capacitor C5. One terminal of the damping resistor R2 is connected to the anode of the semiconductor device. One terminal of the second capacitor C5 is connected to an other terminal of the damping resistor R2, and an other terminal of the second capacitor C5 is connected to the energy supply module. In this case, the energy supply module may obtain an input current through the second capacitor C5, and supply power for the entire driving circuit.

FIG. 10 is a circuit diagram of a fourth exemplary semiconductor apparatus according to an embodiment of this application.

Referring to FIG. 10, in some embodiments, the driving circuit may further include a dynamic clamping module, which includes a lightning arrester R3 and a sixth switch S6. One terminal of the lightning arrester R3 is connected to the anode of the semiconductor device. The sixth switch S6 is connected to an other terminal of the lightning arrester R3, and the other terminal is connected to the anode of the semiconductor device. The logic control module is connected to the sixth switch S6, and is configured to: control the sixth switch S6 to close when a voltage value across the semiconductor device is greater than a withstand value of the lightning arrester R3.

When suffering a lightning strike, the lightning arrester R3 is turned on, and the sixth switch S6 is controlled to close, which can short-circuit the semiconductor device, thereby preventing a current generated by the lightning strike from damaging the semiconductor device. In an embodiment, the lightning arrester R3 may be a metal-oxide lightning arrester R3.

In some embodiments, the driving circuit may further include a current sensor I, disposed on the semiconductor device, and connected to the sampling module. Optionally, the current sensor I is disposed at the cathode of the semiconductor device, to monitor a current passing through the semiconductor device and provide an input for the sampling module.

It should be noted that, the first energy storage member C1, the second energy storage member C2, and the third energy storage member C4 described above may all include at least one capacitor disposed in parallel. The first switch S1, the second switch S2, the third switch S3, the fourth switch S4, the fifth switch S5, and the sixth switch S6 may all include at least one group of semiconductor devices or contactors having turn-on and turn-off capabilities.

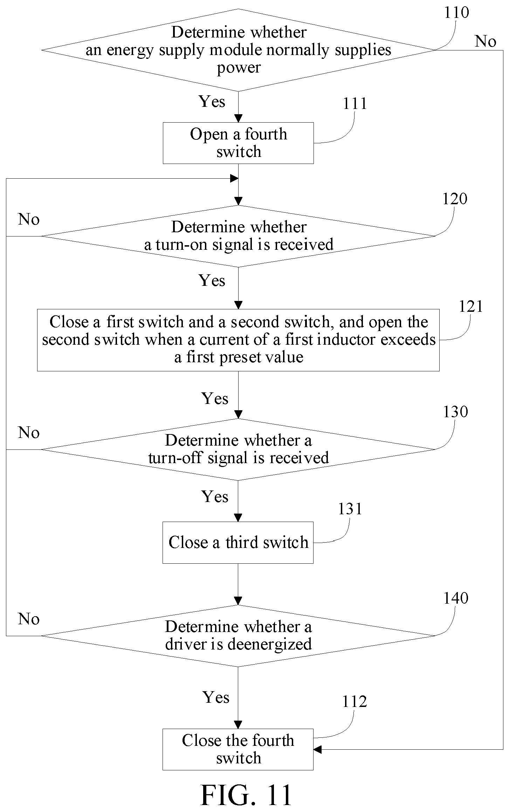

FIG. 11 is a flowchart of a first exemplary control method according to an embodiment of this application.

Referring to FIG. 11, based on the foregoing semiconductor apparatus, this embodiment further provides a method for controlling the semiconductor apparatus, including step 1110 to step 1140.

Step 1110: Determine whether the energy supply module normally supplies power.

In a case in which the energy supply module does not normally supply power, perform step 1111: Close the fourth switch S4. After the fourth switch S4 is closed, the anode and the cathode of the semiconductor device are turned on, to bypass the semiconductor device, thereby avoiding turning on the semiconductor device when the energy supply module is abnormal, and ensuring reliable running of the semiconductor device.

In a case in which the energy supply module normally supplies power, perform step 1112: Open the fourth switch S4. In this way, the semiconductor device is electrically connected to the driving circuit, and the semiconductor device can be controlled by using the driving circuit.

Step 1120: Determine whether the turn-on signal is received.

In a case in which the turn-on signal is not received, continue waiting to receive the turn-on signal. Optionally, the turn-on signal is a turn-on pulse.

In a case in which the turn-on signal is received, perform step 1121: Close the first switch S1 and the second switch S2. In addition, in a case in which the current of the first inductor L1 exceeds the first preset value, the second switch S2 is opened. After the first switch S1 and the second switch S2 are closed, the first energy storage member C1 is discharged, to cause the current of the first inductor L1 to rise. After a peak value of the current of the first inductor L1 reaches the first preset value, the second switch S2 is controlled to open, to cause the current to enter the semiconductor device through the second positive electrode, the spring plate on the upper side, the first positive electrode, and the gate of the semiconductor device, and then return to the positive electrode of the first energy storage member C1 through the cathode of the semiconductor device, the first negative electrode, the spring plate on the lower side, and the second negative electrode sequentially. In this case, the semiconductor device is turned on.

Step 1130: Determine whether a turn-off signal is received.

In a case in which the turn-off signal is not received, perform step 1110: Determine whether the turn-on signal is received.

In a case in which the turn-off signal is received, perform step 1131: Close the third switch S3. After the third switch S3 is closed, the second energy storage member C2 is discharged. The current flows into the semiconductor device through the third switch S3, the second negative electrode, the spring plate on the lower side, the first negative electrode, and the cathode of the semiconductor device sequentially, and then returns to the second energy storage member C2 through the gate of the semiconductor device, the first positive electrode, the spring plate on the upper side, and the second positive electrode sequentially. In this case, the semiconductor device is turned off.

Step 1140: Determine whether the driver is deenergized.

In a case in which the driver is not deenergized, perform step 1110: Determine whether the turn-on signal is received.

In a case in which the driver is deenergized, perform step 1111: Close the fourth switch S4. In other words, after the turn-off signal is received and the semiconductor device is turned off, the anode and the cathode of the semiconductor device are electrically connected again, to cause the semiconductor device to be bypassed, thereby ensuring that the semiconductor device is not turned on.

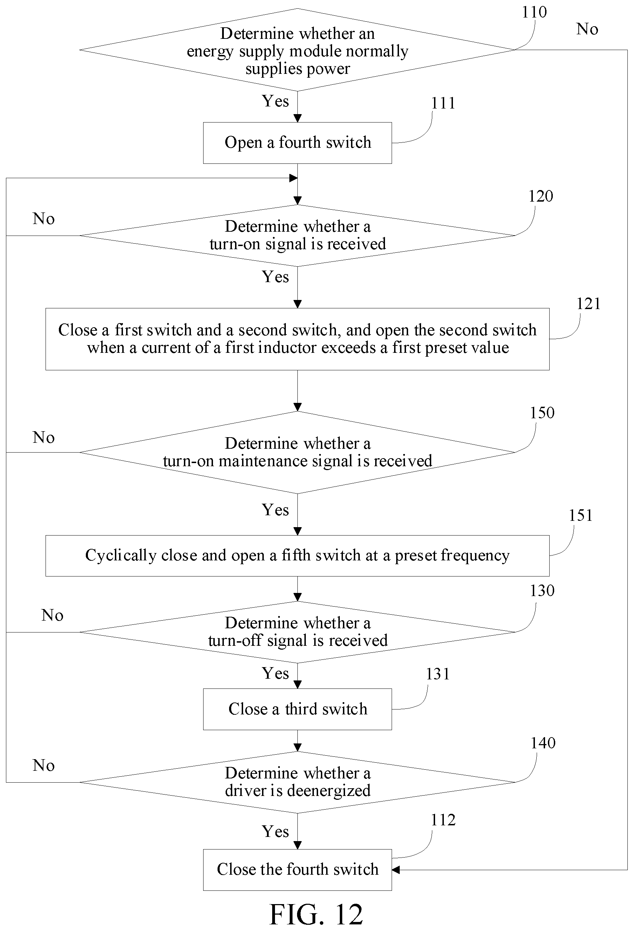

FIG. 12 is a flowchart of a second exemplary control method according to an embodiment of this application.

Referring to FIG. 12, in some embodiments, when the driving circuit includes a turn-on maintenance module, the method for controlling the semiconductor apparatus may include step 1110 to step 1150.

Step 1150: Determine whether a turn-on maintenance signal is received.

In a case in which the turn-on maintenance signal is not received, perform step 1110: Determine whether the turn-on signal is received.

In a case in which the turn-on maintenance signal is received, perform step 1151: Cyclically close and open the fifth switch S5 at a preset frequency. Each time the fifth switch S5 is closed or opened, a forward current can be output to the semiconductor device, to cause the semiconductor device to be continuously turned on.

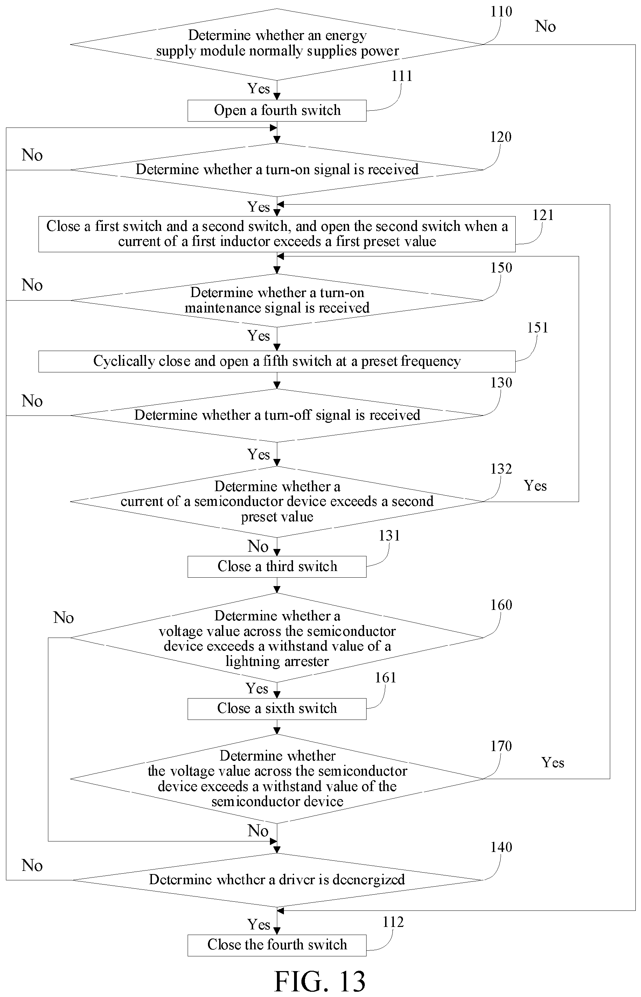

FIG. 13 is a flowchart of a third exemplary control method according to an embodiment of this application.

Referring to FIG. 13, in some embodiments, when the driving circuit further includes a dynamic equalization resistor, a damping loop module, a dynamic clamping module, and a current sensor I, the method for controlling the semiconductor apparatus may include step 1110 to step 1170.

Step 1130: Determine whether a turn-off signal is received.

In a case in which the turn-off signal is not received, perform step 1110: Determine whether the turn-on signal is received.

In a case in which the turn-off signal is received, perform step 1132: Determine whether a current of the semiconductor device exceeds a second preset value.

In a case in which the current of the semiconductor device exceeds the second preset value, perform step 1110: Determine whether a turn-on maintenance signal is received. In this way, damage to the semiconductor device caused by turning off the semiconductor device when the current in the semiconductor device is large is avoided.

When the current of the semiconductor device does not exceed the second preset value, perform step 1131: Close the third switch S3. It is ensured that the current of the semiconductor device is within a safe range, and then the semiconductor device is turned off.

Step 1160: Determine whether a voltage value across the semiconductor device exceeds a withstand value of the lightning arrester R3.

In a case in which the voltage value across the semiconductor device does not exceed the withstand value of the lightning arrester R3, perform step 1140: Determine whether the driver is deenergized.

In a case in which the voltage value across the semiconductor device exceeds the withstand value of the lightning arrester R3, perform step 1161: Close the sixth switch S6. When the voltage value across the semiconductor device exceeds the withstand value of the lightning arrester R3, the lightning arrester R3 is electrically connected, and the semiconductor device may be short-circuited after the sixth switch S6 is closed, to prevent the semiconductor device from being damaged by a lightning strike.

Step 1170: Determine whether a voltage value across the semiconductor device exceeds a withstand value of the semiconductor device.

In a case in which the voltage value across the semiconductor device does not exceed the withstand value of the semiconductor device, perform step 1140: Determine whether the driver is deenergized.

In a case in which the voltage value across the semiconductor device exceeds the withstand value of the semiconductor device, perform 1121: Close the first switch S1 and the second switch S2, and open the second switch S2 when the current of the first inductor L1 exceeds the first preset value. The semiconductor device is turned on again.

According to the foregoing method for controlling the semiconductor device, voltages of the gate and the cathode of the semiconductor device can be dynamically controlled, so that voltage damage does not easily occur on the semiconductor device, thereby improving reliability and safety of the semiconductor device during running.

The embodiments of this application are described above in detail. The principle and implementations of this application are described in this specification by using specific examples. The descriptions of the foregoing embodiments are merely used for helping understand the method and core ideas of this application. In addition, changes or variations made by a person skilled in the art based on the ideas of this application and based on the specific implementations and the application scope of this application shall fall within the protection scope of this application. In conclusion, the content of this specification should not be construed as a limitation on this application.

## Claims

1. A driver, comprising:
a fixing assembly, comprising a mounting member and a connecting member, wherein the connecting member is disposed on the mounting member, and a first positive electrode and a first negative electrode are disposed on the mounting member; and
a driving assembly, comprising a driving board, wherein a second positive electrode and a second negative electrode are disposed on the driving board, wherein
the driving board is movably connected to the connecting member, such that the first positive electrode is connected to the second positive electrode, and the first negative electrode is connected to the second negative electrode.

2. The driver according to claim 1, wherein the connecting member comprises:
an electric conductor, wherein at least two electric conductors are provided, and two of the electric conductors are disposed at an interval on the mounting member and are respectively connected to the first positive electrode and the first negative electrode, wherein
the driving board is inserted between the two electric conductors, and the second positive electrode and the second negative electrode are respectively connected to the two electric conductors.

3. The driver according to claim 2, wherein at least one of the electric conductors is a spring plate, and the spring plate comprises:
a connecting portion, disposed on the mounting member;
a contact portion, disposed on the connecting portion, wherein a part of the contact portion is disposed at an interval from the connecting portion, and a side that faces away from the contact portion is connected to the driving board; and
a support portion, connected between the contact portion and the connecting portion.

4. The driver according to any one of claims 1 to 3, wherein the driving assembly further comprises a housing, provided with a mounting cavity, wherein
the driving board is disposed in the mounting cavity.

5. The driver according to claim 4, wherein one of the housing and the mounting member is provided with an insertion slot, an insertion member is disposed on an other of the housing and the mounting member, and the insertion member is inserted into the insertion slot.

6. A semiconductor apparatus, comprising:
a semiconductor device; and
the driver according to any one of claims 1 to 5, wherein the semiconductor device is disposed on the mounting member, the first positive electrode is connected to a gate of the semiconductor device, and the first negative electrode is connected to a cathode of the semiconductor device.

7. The semiconductor apparatus according to claim 6, further comprising a heat dissipator disposed on the semiconductor device.

8. The semiconductor apparatus according to claim 6, wherein a driving circuit is disposed on the driving board, and the driving circuit comprises:
a logic control module, configured to receive and feed back a control signal;
a turn-on triggering module, configured to input a forward current to the semiconductor device when the logic control module receives a turn-on signal, to control the semiconductor device to be turned on;
a turn-off triggering module, configured to input a reverse current to the semiconductor device when the logic control module receives a turn-off signal, to control the semiconductor device to be turned off;
an energy supply module, configured to supply power to the logic control module, the turn-on triggering module, and the turn-off triggering module;
a sampling module, configured to send an abnormal signal to the logic control module when the energy supply module abnormally runs; and
a bypass module, configured to connect the gate and the cathode of the semiconductor device when the logic control module receives the abnormal signal.

9. The semiconductor apparatus according to claim 7, wherein the turn-on triggering module comprises:
a first energy storage member, wherein a positive electrode of the first energy storage member is connected to the second negative electrode, and a negative electrode of the first energy storage member is connected to the second positive electrode;
a first diode, wherein an anode of the first diode is connected to the second positive electrode;
a second diode, wherein a cathode of the second diode is connected to the second positive electrode;
a first inductor, wherein an input terminal of the first inductor is connected to a cathode of the first diode, and an output terminal of the first inductor is connected to an anode of the second diode;
a first switch, wherein one terminal of the first switch is connected to the second negative electrode, and another terminal of the first switch is connected to the input terminal of the first inductor; and
a second switch, wherein one terminal of the second switch is connected to the anode of the second diode, and another terminal of the second switch is connected to the second positive electrode, wherein
the logic control module is connected to the first switch and the second switch and is configured to control the first switch and the second switch to close when the turn-on signal is received, and control the second switch to open when a current of the first inductor exceeds a first preset value.

10. The semiconductor apparatus according to claim 9, wherein the turn-off triggering module comprises:
a second energy storage member, wherein a positive electrode of the second energy storage member is connected to the second negative electrode; and
a third switch, wherein one terminal of the third switch is connected to a negative electrode of the second energy storage member, and another terminal of the third switch is connected to the second positive electrode, wherein
the logic control module is connected to the third switch and is configured to control the third switch to close when the turn-off signal is received.

11. The semiconductor apparatus according to claim 10, wherein the bypass module comprises:
a fourth switch, wherein one terminal of the fourth switch is connected to the second positive electrode, and another terminal of the fourth switch is connected to the second negative electrode, wherein
the logic control module is connected to the fourth switch and is configured to control the fourth switch to close when the abnormal signal is received.

12. The semiconductor apparatus according to claim 11, wherein the driving circuit further comprises a trigger maintenance module, and the trigger maintenance module comprises:
a third energy storage member, wherein a positive electrode of the third energy storage member is connected to the second negative electrode;
a second inductor, wherein an input terminal of the second inductor is connected to the second negative electrode;
a third inductor, wherein an output terminal of the third inductor is connected to the second positive electrode;
a third diode, wherein an anode of the third diode is connected to an output terminal of the second inductor, and a cathode of the third diode is connected to an input terminal of the third inductor;
a first capacitor, wherein one terminal of the first capacitor is connected to the second negative electrode, and another terminal of the first capacitor is connected to an output terminal of the third inductor; and
a fifth switch, wherein one terminal of the fifth switch is connected to the anode of the third diode, and another terminal of the fifth switch is connected to a negative electrode of the third energy storage member, wherein
the logic control module is connected to the fifth switch and is configured to control the fifth switch to continuously perform closing and opening actions at a preset frequency when a turn-on triggering maintenance signal is received.

13. The semiconductor apparatus according to claim 12, wherein the driving circuit further comprises a static voltage equalization resistor, one terminal of the static voltage equalization resistor is connected to an anode of the semiconductor device, and another terminal of the static voltage equalization resistor is connected to the sampling module.

14. The semiconductor apparatus according to claim 13, further comprising a damping loop module, wherein the damping loop module comprises:
a damping resistor, wherein one terminal of the damping resistor is connected to the anode of the semiconductor device; and
a second capacitor, wherein one terminal of the second capacitor is connected to another terminal of the damping resistor, and another terminal of the second capacitor is connected to the energy supply module.

15. The semiconductor apparatus according to claim 14, wherein the driving circuit further comprises a dynamic clamping module, and the dynamic clamping module comprises:
a lightning arrester, wherein one terminal of the lightning arrester is connected to the anode of the semiconductor device; and
a sixth switch, wherein one terminal of the sixth switch is connected to another terminal of the lightning arrester, and another terminal of the sixth switch is connected to the anode of the semiconductor device, wherein
the logic control module is connected to the sixth switch, and is configured to control the sixth switch to close when a voltage value across the semiconductor device is greater than a withstand value of the lightning arrester.

16. The semiconductor apparatus according to claim 15, wherein the driving circuit further comprises a current sensor, disposed on the semiconductor device, and connected to the sampling module.

17. A method for controlling the semiconductor apparatus according to any one of claims 11 to 16, comprising:
determining whether the energy supply module normally supplies power; and
closing the fourth switch in a case in which the energy supply module does not normally supply power; or
opening the fourth switch in a case in which the energy supply module normally supplies power;
determining whether the turn-on signal is received; and
closing the first switch and the second switch in a case in which the turn-on signal is received, and opening the second switch in a case in which the current of the first inductor exceeds the first preset value;
determining whether the turn-off signal is received; and
determining, in a case in which the turn-off signal is not received, whether the turn-on signal is received; or
closing the third switch in a case in which the turn-off signal is received; and
determining whether the driver is deenergized; and
determining, in a case in which the driver is not deenergized, whether the turn-on signal is received; or
closing the fourth switch in a case in which the driver is deenergized.

18. A method for controlling the semiconductor apparatus according to any one of claims 12 to 16, comprising:
determining whether the energy supply module normally supplies power; and
closing the fourth switch in a case in which the energy supply module does not normally supply power; or
opening the fourth switch in a case in which the energy supply module normally supplies power;
determining whether the turn-on signal is received; and
closing the first switch and the second switch in a case in which the turn-on signal is received, and opening the second switch in a case in which the current of the first inductor exceeds the first preset value;
determining whether a turn-on maintenance signal is received; and
determining, in a case in which the turn-on maintenance signal is not received, whether the turn-on signal is received; or
cyclically closing and opening the fifth switch at the preset frequency in a case in which the turn-on maintenance signal is received;
determining whether the turn-off signal is received; and
determining, in a case in which the turn-off signal is not received, whether the turn-on signal is received; or
closing the third switch in a case in which the turn-off signal is received; and
determining whether the driver is deenergized; and
determining, in a case in which the driver is not deenergized, whether the turn-on signal is received; or
closing the fourth switch in a case in which the driver is deenergized.

19. A method for controlling the semiconductor apparatus according to claim 15 or 16, comprising:
determining whether the energy supply module normally supplies power; and
closing the fourth switch in a case in which the energy supply module does not normally supply power; or
opening the fourth switch in a case in which the energy supply module normally supplies power;
determining whether the turn-on signal is received; and
closing the first switch and the second switch in a case in which the turn-on signal is received, and opening the second switch in a case in which the current of the first inductor exceeds the first preset value;
determining whether a turn-on maintenance signal is received; and
determining, in a case in which the turn-on maintenance signal is not received, whether the turn-on signal is received; or
cyclically closing and opening the fifth switch at the preset frequency in a case in which the turn-on maintenance signal is received;
determining whether the turn-off signal is received; and
determining, in a case in which the turn-off signal is not received, whether the turn-on signal is received; or
determining, in a case in which the turn-off signal is received, whether a current of the semiconductor device exceeds a second preset value; and
determining, in a case in which the current of the semiconductor device exceeds the second preset value, whether the turn-on maintenance signal is received; or
closing the third switch in a case in which the current of the semiconductor device does not exceed the second preset value;
determining whether the voltage value across the semiconductor device exceeds the withstand value of the lightning arrester; and
determining, in a case in which the voltage value across the semiconductor device does not exceed the withstand value of the lightning arrester, whether the driver is deenergized; or
closing the sixth switch in a case in which the voltage value across the semiconductor device exceeds the withstand value of the lightning arrester; and
determining whether the voltage value across the semiconductor device exceeds a withstand value of the semiconductor device; and
determining, in a case in which the voltage value across the semiconductor device does not exceed the withstand value of the semiconductor device, whether the driver is deenergized; or
closing the first switch and the second switch in a case in which the voltage value across the semiconductor device exceeds the withstand value of the semiconductor device, and opening the second switch in a case in which the current of the first inductor exceeds the first preset value, wherein
in a case in which the driver is not deenergized, whether the turn-on signal is received is determined, and in a case in which the driver is deenergized, the fourth switch is closed.
